# EUROPÄISCHE PATENTANMELDUNG

(11) **EP 2 196 811 A2**
(43) Veröffentlichungstag der Anmeldung: **16.06.2010**
(21) Anmeldenummer: 09400057.7
(22) Anmeldetag: 26.11.2009
(51) Int. Cl.: G01R 15/20, G01R 1/20

(54) **Verfahren und Vorrichtung zur Messung von elektrischen Strömen**

(30) Priorität: 28.11.2008 DE 102008061006
(71) Anmelder: ESW GmbH, 22876 Wedel (DE)
(72) Erfinder: Wenske, Jan, Dr., 21449 Radbruch (DE); Scheffel, Jürgen, 22850 Norderstedt (DE); Kobisch, Ulf, 22761 Hamburg (DE)
(74) Vertreter: Klickow, Hans-Henning

(57) **Zusammenfassung**

Das Verfahren und die Vorrichtung dienen zur Messung von elektrischen Strömen. Unter Verwendung mindestens eines Sensors wird eine von der Größe des zu messenden Stromes abhängige Feldstärke gemessen. Der zu messende Strom wird auf einander im wesentlichen gegenüberliegenden Seiten des Sensors mit relativ zu einander wenigstens teilweise entgegengesetzten Richtungskomponenten am Sensor vorbeigeleitet. Als Sensor kann mindestens ein Magnetfeldsensor verwendet werden.

## Beschreibung

Die Erfindung betrifft ein Verfahren zur Messung von elektrischen Strömen, bei dem unter Verwendung mindestens eines Sensors eine von der Größe des zu messenden Stromes abhängige magnetische Feldstärke gemessen wird.

Die Erfindung betrifft darüber hinaus eine Vorrichtung zur Messung von elektrischen Strömen, die mindestens einen Sensor zur Erfassung einer von der Größe des Stromes abhängigen magnetischen Feldstärke aufweist.

Derartige Verfahren und Vorrichtungen sind bereits in unterschiedlichen Ausführungsformen bekannt. Insbesondere bei einer galvanisch getrennten Strommessung im Bereich von größeren Strömen, typischerweise mit Werten von mehreren 100 Ampere, können aber bislang aber noch nicht alle Anforderungen an eine hohe Empfindlichkeit und Störungssicherheit bei gleichzeitig kompaktem Gesamtaufbau erfüllt werden. Ein typisches Anwendungsgebiet für derartige Strommessungen sind Gleichstrom- und/oder Wechselstrommessungen bei Umrichteranwendungen.

Aufgabe der vorliegenden Erfindung ist es, ein Verfahren der einleitend genannten Art derart zu verbessern, daß eine hohe Genauigkeit sowie eine hohe Empfindlichkeit der Strommessung unterstützt wird.

Diese Aufgabe wird erfindungsgemäß dadurch gelöst, daß der zu messende Strom auf einander im wesentlichen gegenüberliegenden Seiten des Sensors mit wenigstens teilweise einander entgegengesetzten Richtungskomponenten am Sensor vorbeigeleitet wird.

Weitere Aufgabe der vorliegenden Erfindung ist es, eine Vorrichtung der einleitend genannten Art derart zu gestalten, daß eine hohe Empfindlichkeit bei gleichzeitig hoher Genauigkeit erreicht wird.

Diese Aufgabe wird erfindungsgemäß dadurch gelöst, daß sich entlang einander im wesentlichen gegenüberliegender Seiten des Sensors jeweils mindestens Bereiche eines den elektrischen Strom führenden Leiters derart erstrecken, daß die Bereiche mindestens in einer Komponente einer Flußrichtung des elektrischen Stromes hintereinander angeordnet sind.

Durch die Stromführung derart, daß der zu messende Strom auf einander entgegengesetzten Seiten des Sensors mit entgegengesetzten Richtungskomponenten ausgerichtet ist, erfolgt im Bereich des Sensors eine gleichsinnige Überlagerung der jeweils generierten magnetischen Felder. Es erfolgt somit insbesondere keine Kompensation von Feldkomponenten, die bei einer gleichsinnigen Vorbeiführung des Stromes auf einander entgegengesetzten Seiten des Sensors generiert würde und die zu einer erheblichen Reduzierung der Empfindlichkeit führt.

Durch die gleichsinnige Überlagerung der Feldkomponenten ist es insbesondere möglich, auf einen das zu messende Feld bündelnden Kern aus einem ferromagnetischen Material zu verzichten. Dies hat den wesentlichen Vorteil, daß der Sensor nicht Sättigungseffekten unterliegt. Eine derartige Sättigung kann beispielsweise hervorgerufen werden, wenn im Zusammenhang mit Umrichtern eine Leistungsendstufe im Kurzschluß betrieben wird. Durch die Vermeidung von Sättigungseffekten wird auch eine Eigenerwärmung des Sensors vermieden. Eine Sensortemperatur, die die Einsatzfähigkeit des Sensors durch Überschreiten einer maximal zulässigen Betriebstemperatur begrenzen würde, wird somit im wesentlichen nur von den herrschenden Umgebungsbedingungen und nicht durch eine im Bereich des Sensors umgesetzte Verlustleistung bestimmt. Eine derartige Verlustleistung kann beispielsweise durch Ummagnetisierungsverluste entstehen.

Als Sensor können grundsätzlich Magnetfeldsensoren (z.B. Hallelemente, magnetoresistive Elemente) verwendet werden.

Gemäß einer Ausführungsform ist vorgesehen, daß die Strommessung im Bereich einer Stromschiene durchgeführt wird.

Eine besonders hohe Empfindlichkeit läßt sich dadurch erreichen, daß die Stromschiene benachbart zum Sensor einen U-förmigen oder L-förmigen Verlauf aufweist.

Gemäß einer anderen Ausführungsform ist es auch möglich, daß eine Strommessung im Bereich eines Kabels durchgeführt wird.

Eine weitere Erhöhung der Empfindlichkeit kann dadurch erreicht werden, daß der Sensor mindestens teilweise vom Kabel umschlungen wird.

Die Funktionssicherheit kann dadurch erhöht werden, daß mindestens ein Sensortest durchgeführt wird.

Insbesondere ist daran gedacht, daß der Sensortest unter Verwendung mindestens einer Spule durchgeführt wird. Entscheidend ist hierbei die Generierung eines Magnetfeldes.

Eine weitere Erhöhung der Funktionssicherheit kann dadurch erreicht werden, daß im Bereich des Sensors eine Temperaturüberwachung durchgeführt wird.

Beeinträchtigungen der Meßgenauigkeit durch Fremdfelder können dadurch vermieden werden, daß im Bereich des Sensors eine elektromagnetische Abschirmung durchgeführt wird. Dies ist insbesondere bei der Existenz von Störfeldern oder benachbarten Leitungen zweckmäßig.

Eine besonders einfache Montage und Demontage wird dadurch unterstützt, daß ein den Sensor positionierendes Sensorgehäuse unter Verwendung mindestens eines Kabelbinders räumlich fixiert wird. Ebenfalls ist an die Verwendung von Schrauben oder Schellen sowie an Verklebungen gedacht.

In den Zeichnungen sind Ausführungsbeispiele der Erfindung schematisch dargestellt. Es zeigen:
- Fig. 1: eine Seitenansicht einer Stromschiene mit U-förmiger Leitungsführung im Bereich eines Einbauplatzes für einen Stromsensor,
- Fig. 2: eine gegenüber Fig. 1 abgewandelte Ausführungsform mit gebogenem Verlauf der Stromschiene sowie zugeordneter Sensorplatine,
- Fig. 3: eine Prinzipdarstellung zur Veranschaulichung der Wirkungsweise,
- Fig. 4: eine perspektivische Darstellung eines Stromsensors mit Magnetfeldsensor, der in ein Halterungsprofil einer Stromschiene eingesetzt ist,
- Fig. 5: eine perspektivische Explosionsdarstellung des Sensors gemäß Fig. 4 ohne das den Sensor aufnehmendes Halterungsprofil,
- Fig. 6: eine Darstellung einer Stromschiene mit L-förmiger Leitungsführung im Bereich eines Einbauraumes für den Stromsensor,
- Fig. 7: eine perspektivische Darstellung eines im Bereich einer Stromschiene angeordneten Stromsensors mit integrierter Sensortestfunktionalität unter Verwendung von Luftspulen und
- Fig. 8: eine perspektivische Seitenansicht eines Führungselementes zur Kabelpositionierung in einer Umgebung des Sensors.

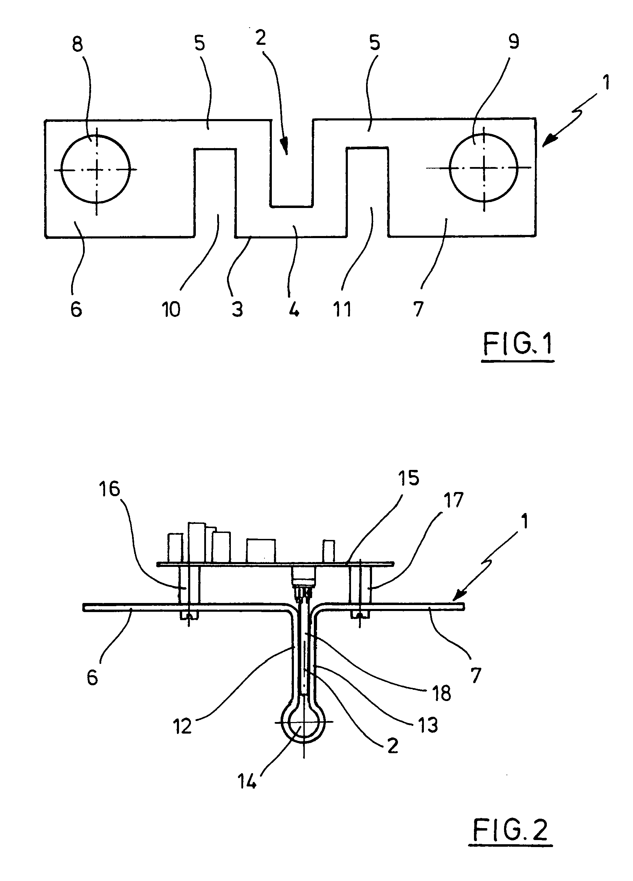

Fig. 1 zeigt eine Seitenansicht einer Stromschiene (1), die im Bereich eines Sensoraufnahmeraumes (2) mit einer U-förmigen Leitungsführung (3) versehen ist. Einem Basisschenkel (4) abgewandte Enden der Leitungsführung (3) sind hierbei typischerweise über Querstege (5) mit Hauptbereichen (6, 7) der Stromschiene (1) verbunden. Die Hauptbereiche (6, 7) weisen typischerweise Ausnehmungen (8, 9) zur Befestigung der Stromschiene (1) im Bereich von nicht dargestellten Gegenelementen auf. Seitenschenkel der u-förmigen Leitungsführung (3) sind von Einschnitten (10, 11) von den Hauptbereichen (6, 7) derart getrennt, daß eine Verbindung nur von den Querstegen (5) realisiert ist. Bei derartigen Stromschienen (1) können der Sensoraufnahmeraum (3) und die Einschnitte (10, 11) beispielsweise bei größeren Materialdicken durch Ausfräsungen oder bei kleineren Materialdicken durch Umbiegungen im Bereich der Stromschiene (1) erzeugt werden. Bei längeren Stromschienen (1) werden typischer Weise die Querstege (5) entsprechend länger ausgebildet.

Fig. 2 zeigt eine gegenüber Fig. 1 abgewandelte Ausführungsform zur Bereitstellung einer der Konstruktion in Fig. 1 elektrisch entsprechenden Stromführung im Bereich des Sensoraufnahmeraums (1). Hauptbereiche (6, 7) der Stromschiene (1) sind hierbei in Querschenkel (12, 13) umgebogen, die sich vorzugsweise parallel zueinander erstrecken und den Sensoraufnahmeraum (2) begrenzen. Der Sensoraufnahmeraum (2) liegt zwischen den Querschenkeln (12, 13) im Bereich eines homogenen Feldraumes. Die Querschenkel (12, 13) sind durch einen gerundeten Biegungsbereich (14) ineinander übergeleitet, wobei der Biegungsbereich (14) einen geeigneten Biegeradius aufweist, um die Materialeigenschaften der Stromschiene (1) zu berücksichtigen. Typischerweise besteht die Stromschiene (1) aus Kupfer oder einer Kupferlegierung.

Fig. 2 veranschaulicht ebenfalls die Anordnung einer Sensorplatine (15) im Bereich der Stromschiene (1). Die Sensorplatine (15) ist hierbei von Halterungselementen (16, 17) im Bereich der Ausnehmungen (8, 9) fixiert. In den Bereich des Sensoraufnahmeraumes (2) ragt ein Sensor (18) hinein, der als ein Magnetfeldsensor ausgebildet ist.

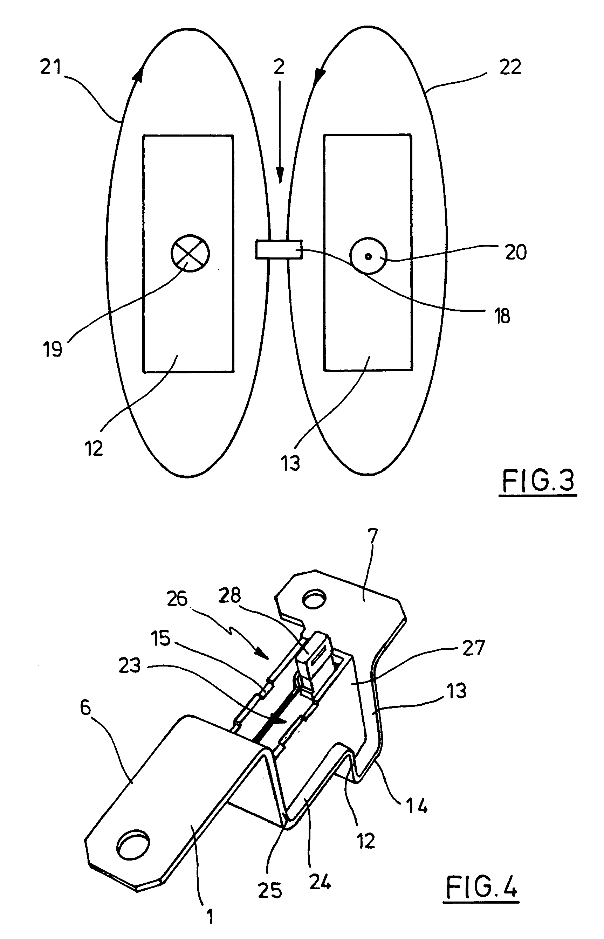

Fig. 3 zeigt eine schematische Darstellung zur Veranschaulichung des Wirkungsprinzips der Sensoranordnung. Fig. 3 entspricht beispielsweise einem Querschnitt durch die den Sensoraufnahmeraum (2) begrenzenden Querschenkel (12, 13). Im Bereich der Querschenkel (12, 13) sind die einander entgegengesetzten Stromflußrichtungen (19, 20) sowie typische Feldlinienverläufe (21, 22) der magnetischen Feldstärke eingezeichnet. Es ist zu erkennen, daß sich die Feldlinienverläufe im Bereich des Sensoraufnahmeraumes (2) gleichsinnig überlagern und hierdurch die Feldstärke und somit die Empfindlichkeit der Messung erhöhen.

Fig. 4 zeigt eine Ausführungsform, bei der die den Sensor (18) halternde Sensorplatine (15) in einem Sensorgehäuse (23) angeordnet sind, daß von einer speziell geformten Stromschiene (1) gehaltert ist. Die Stromschiene (1) ist hierbei ähnlich zum Herstellungsprinzip gemäß der Ausführungsform in Fig. 2 realisiert, die Biegekontur ist jedoch abweichend zu Fig. 2 gestaltet. Insbesondere erstreckt sich der Querschenkel (12) hierbei nicht parallel zur gesamten Ausdehnung des Querschenkels (13), sondern ausgehend vom Biegungsbereich (14) nur entlang eines Teiles des Querschenkels (13).

Im Bereich seiner dem Biegungsbereich (14) abgewandten Ausdehnung ist der Querschenkel (12) in eine Ebene umgebogen, die sich im wesentlichen parallel zu einer von den Hauptbereichen (6, 7) der Stromschiene (1) aufgespannten Ebene und mit einem Abstand zu dieser Ebene erstreckt. Es wird hierdurch ein Auflageschenkel (24) bereitgestellt, der über eine weitere Umbiegung in einen Anlageschenkel (25) übergeleitet ist, der seinerseits wiederum über eine Umbiegung an den Hauptbereich (6) der Stromschiene (1) angrenzt. Ein Teilbereich des Querschenkels (13), der Auflageschenkel (24) und der Anlageschenkel (25) begrenzen somit einen Gehäuseaufnahmeraum (26) für das Sensorgehäuse (23).

Die Stromschiene (1) und der Sensor bzw. das Sensorgehäuse (23) sind bei dieser Ausführungsform durch die realisierte mechanische Fixierung als eine Einheit ausgebildet. Die geometrische Ausführung der Stromschiene (1) sowie die räumliche Anordnung des Sensors relativ zur Stromschiene (1) beeinflussen zum einen die Messung, sind zum anderen aber durch die feste mechanische Zuordnung konstant. Der Sensor kann somit in einfacher Art und Weise kalibriert werden. Während der gesamten Durchführung der Messung ist die Lage des Sensors bzw. die Lage der Sensorplatine (15) relativ zur Stromschiene (1) konstant.

An der Sensorplatine (15) ist über eine Steckverbindung (27) ein Anschlußelement (28) gehaltert. Das Anschlußelement (28) weist beim dargestellten Ausführungsbeispiel eine Einführöffnung mit Kontaktierung für ein Flachbandkabel auf, das nicht dargestellt ist. Es können beispielsweise Anschlüsse für eine Versorgungsspannung, einen Signalausgang, einen Ausgangsbezug sowie für ein Triggersignal zur Durchführung eines Selbsttest vorhanden sein. Optional ist es auch möglich, einen Anschluß für das Ausgangssignal des internen Temperatursensors vorzusehen.

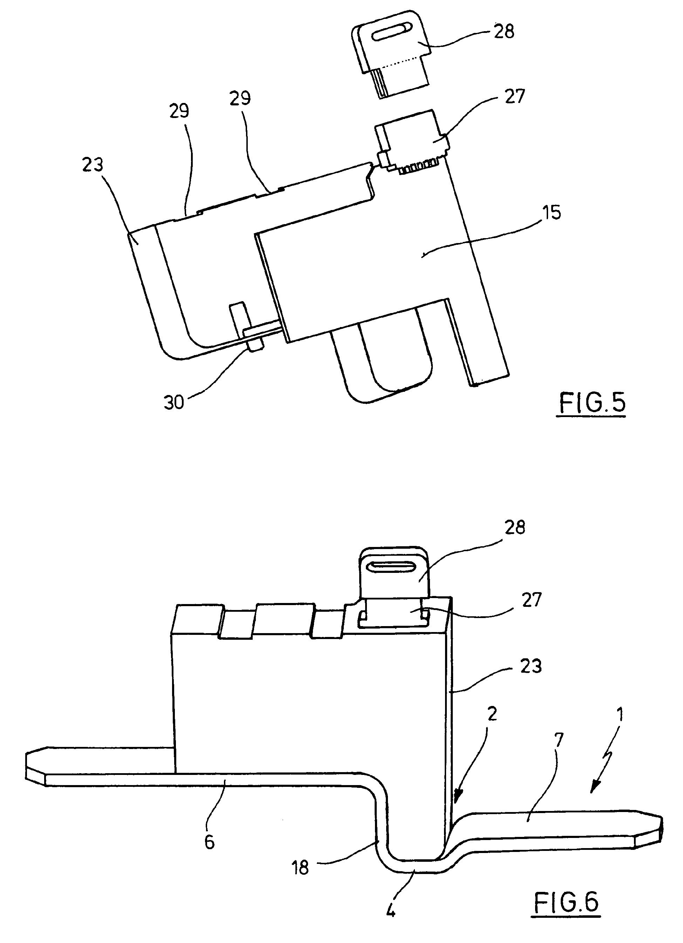

Fig. 5 zeigt in einer Explosionsdarstellung das Sensorgehäuse (23) mit herausgenommener Sensorplatine (15) und aus dem Steckverbinder (27) herausgezogenem Anschlußelement (28). Es ist zu erkennen, daß das Sensorgehäuse (23) Ausnehmungen (29) aufweist, die zur Positionierung von nicht dargestellten Kabelbindern dienen, die das Sensorgehäuse (23) im Bereich des Gehäuseaufnahmeraumes (26) fixieren. Eine Seitenfixierung des Sensorgehäuses (23) im Bereich des Gehäuseaufnahmeraumes (26) wird beispielsweise durch eine Gehäusenase (30) unterstützt, die in eine zugeordnete Ausnehmung im Bereich des Auflageschenkels (24) einführbar ist.

Fig. 6 zeigt eine gegenüber der Ausführungsform in Fig. 1 bzw. Fig. 4 abgewandelte Ausbildung der Stromschiene (1). Im Bereich des Sensoraufnahmeraumes (2) ist hier eine L-förmige Kontur der Stromschiene (1) vorgesehen. Die Vereinfachung der Konstruktion gemäß Fig. 6 bei einem Vergleich mit der Konstruktion gemäß Fig. 1 oder Fig. 4 führt allerdings dazu, daß nicht die volle Empfindlichkeit der Anordnung gemäß Fig. 1 oder Fig. 4 erreicht werden kann.

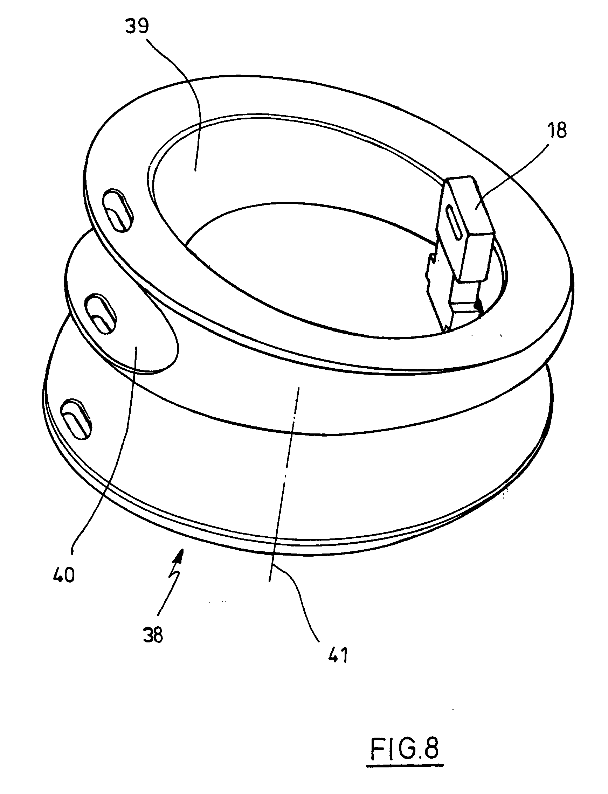

Die erfindungsgemäße Stromführung benachbart zum Sensor (18) ist aber nicht auf Stromschienen (1) begrenzt, sondern kann auch bei kabel- bzw. leitungsgebundenen Stromführungen eingesetzt werden. Bei Verwendung derartiger Kabel oder Leitungen ist es sogar möglich, eine entsprechende mehrfache Vorbeiführung des Stromes am Sensor (18) zu realisieren und hierdurch nochmals eine Steigerung der Empfindlichkeit zu erreichen. Bezugnehmend auf Fig. 8 wird später nochmals auf diese Variante eingegangen.

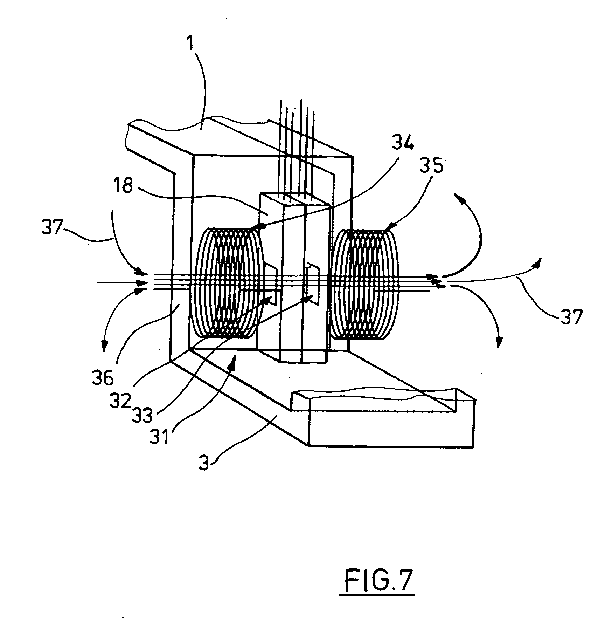

Fig. 7 zeigt die Verwendung eines Sensors (18) mit einer zugeordneten Testeinrichtung (31). Im Bereich des Sensors (18) sind zwei Sensorelemente (32, 33) angeordnet, die beispielsweise als Hallelemente ausgebildet sind. Jeweils benachbart zu den Magnetfeldsensoren (32, 33) sind Spulen (34, 35) positioniert. Die Spulen (34, 35) sind beispielsweise als Luftspulen ausgeführt. Durch die Anordnung der beiden Spulen (34, 35) wird im Bereich der Magnetfeldsensoren (32, 33) ein Feld (36) erzeugt. Im Bereich der den Hallelementen (32, 33) abgewandten Umgebungsbereiche der Spulen (34, 35) ergibt sich ein Streufeld (37).

Unter Verwendung der Spulen (34, 35) ist es möglich, die Sensorfunktion, insbesondere die Messung der Magnetfeldstärke mit Hilfe der Magnetfeldsensoren (32, 33), zu testen. Es kann ein der magnetischen Feldstärke proportionales Spannungs- oder Stromausgangssignal generiert werden, so daß die Prüfung des Sensors (18) unabhängig von einem tatsächlichen Stromfluß in der Stromschiene (1) überprüft werden kann. Eine Positionierung der Spulen (34, 35) erfolgt typischerweise derart, daß die Hallelemente (32, 33) im Bereich der größten Flußdichte der Spulen (34, 35) liegen.

Eine Anregung der Spulen (34, 35) kann beispielsweise direkt oder durch ein induziertes Steuersignal erfolgen. Ein zum Erregerstrom proportionales Ausgangssignal des Sensors (18) ergibt sich bei einem funktionsfähigen Sensor (18), bei Abweichungen kann auf Funktionsstörungen geschlossen werden.

Gemäß einem vereinfachten Sensortest wird nur überprüft, ob es bei einer Erregung der Spulen (34, 35) überhaupt zur Generierung eines Ausgangssignals des Sensor (18) kommt. Die Verwendung von kernlosen Luftspulen (34, 35) vermeidet eine Veränderung des magnetischen Meßkreises des Sensorsystems.

Eine Rückwirkung auf die Sensorfunktion im normalen Meßbetrieb ist somit ausgeschlossen. Bei der Verwendung von Spulen (34, 35) mit einer vergleichsweise hohen Windungszahl ist es möglich, geringe Erregerströme, typischerweise kleiner als 1 Ampere, zu verwenden, um den Sensor (18) im vollständigen vorgesehenen Aussteuerungsbereich zu überprüfen.

Die Verwendung der Testeinrichtung (31) gemäß Fig. 7 kann auch für weitere Anwendungen genutzt werden. Beispielsweise ist es möglich, bei einem Einschalten der Versorgungsspannung eine Erregung der Spulenanordnung durchzuführen. Durch eine Auswertungseinrichtung wird das Erreichen von vorgebbaren Schwellwerten für die Sensorausgangssignale überprüft und gegebenenfalls abgespeichert. Bei einem Erreichen der vorgegebenen Schwellwerte wird der Sensor freigegeben. Bei einem Nichterreichen der Schwellwerte wird der Sensor durch einen von der Steuerung generierten Offset in eine positive oder negative Aussteuerungsgrenze getrieben. Fehlfunktionen des Sensors beim Einschalten können hierdurch sicher detektiert werden.

Bei einer Verwendung der Sensoranordnung im Zusammenhang mit Ausgangsendstufen kann eine derartige Aussteuerung des Sensors an der Aussteuerungsgrenze als kritischer Betriebszustand detektiert werden, der beispielsweise zu einer von der Steuerung generierten schnellen Sperre der Ausgangsendstufen führt. Ein Umrichter wird hierdurch bei einem Einschalten mit defekten Stromsensoren (18) automatisch in einen sicheren Zustand gebracht.

Im Bereich der Sensorplatine (15) kann ein Temperatursensor angeordnet werden, und es ist darüber hinaus möglich, die Versorgungsspannung für die Magnetfeldsensoren (32, 33) zu überwachen. Auch hier ist es möglich, bei einem Überschreiten von vorgegebenen Schwellwerten den Sensorausgang wie vorstehend bereits erläutert durch Verwendung eines Offsets in eine positive oder negative Aussteuerungsgrenze zu treiben.

Ein wesentlicher Vorteil des vorstehend beschriebenen Überwachungskonzeptes besteht darin, daß die Steuerung keine zusätzlichen Eingangskanäle benötigt. Hinsichtlich seiner Anschlüsse ist der erfindungsgemäße Sensor (18) somit kompatibel zu üblichen Sensoren ohne entsprechende Überwachungsfunktion.

Eine Anwendung des Sensors (18) kann sowohl im Bereich der Messung von Gleichströmen als auch im Bereich der Messung von Wechselströmen erfolgen. Problemlos realisierbar sind die Messung von Strömen bis zu einer Frequenz von etwa 100 kHz.

Fig. 8 zeigt ein Führungselement (38) zur Positionierung eines nicht dargestellten Kabels, wobei über den Sensor (18) der im Bereich des Kabels fließende Strom gemessen werden soll. Das Führungselement (38) weist eine hülsenartige oder ringartige Grundkontur auf, wobei sich in einer Wandung (39) des Führungselementes (38) außenseitig ein Halterungsprofil (40) für das Kabel erstreckt, das ähnlich zu einem Gewindegang verläuft. Typischerweise verläuft das gewindeartige Halterungsprofil (40) etwa einmal um den Außenumfang des Führungselementes (38) herum. Unter Berücksichtigung dieser Geometrie weist das Führungselement in Richtung einer Längsachse (41) an unterschiedlichen Umfangspositionen eine unterschiedliche Höhe auf, die durch den Verlauf des Halterungsprofils (40) vorgegeben ist.

Abweichend von der dargestellten einfachen Umschlingung des Sensors (18) mit dem entsprechenden Kabel ist es grundsätzlich auch möglich, andere Mehrfachumläufe des Kabels vorzugeben. Das Führungselement (38) würde hierzu bei gleicher Kabeldicke in Längsrichtung (48) höher ausgeführt sein oder bei geringerer Kabeldicke ein entsprechend mehrfach umlaufendes Halterungsprofil (40) aufweisen. Ebenfalls ist es denkbar, nur eine teilweise Umschlingung des Sensors zu realisieren und das Kabel nur U-förmig oder L-förmig umzulenken.

## Patentansprüche

1. Verfahren zur Messung von elektrischen Strömen, bei dem unter Verwendung mindestens eines Sensors eine von der Größe des zu messenden Stromes abhängige magnetische Feldstärke gemessen wird, **dadurch gekennzeichnet, daß** der zu messende Strom aufeinander im wesentlichen gegenüberliegenden Seiten des Sensors mit wenigstens teilweise einander entgegengesetzten Richtungskomponenten am Sensor vorbeigeleitet wird.

2. Verfahren nach Anspruch 1, **dadurch gekennzeichnet, daß** die Strommessung im Bereich einer Stromschiene (1) durchgeführt wird.

3. Verfahren nach Anspruch 1 oder 2, **dadurch gekennzeichnet, daß** die Stromschiene (1) benachbart zum Magnetfeldsensor ein u-förmiges Profil aufweist.

4. Verfahren nach Anspruch 1, **dadurch gekennzeichnet, daß** eine Strommessung im Bereich eines Kabels durchgeführt wird.

5. Verfahren nach Anspruch 4, **dadurch gekennzeichnet, daß** das Kabel mindestens einfach am Magnetfeldsensor vorbeigeführt wird.

6. Verfahren nach einem der Ansprüche 1 bis 5, **dadurch gekennzeichnet, daß** mindestens ein Sensortest durchgeführt wird.

7. Verfahren nach Anspruch 6, **dadurch gekennzeichnet, daß** der Sensortest unter Verwendung mindestens einer Spule durchgeführt wird.

8. Verfahren nach einem der Ansprüche 1 bis 7, **dadurch gekennzeichnet, daß** im Bereich des Sensors eine Temperaturüberwachung durchgeführt wird.

9. Verfahren nach einem der Ansprüche 1 bis 8, **dadurch gekennzeichnet, daß** im Bereich des Sensors eine elektromagnetische Abschirmung durchgeführt wird.

10. Verfahren nach einem der Ansprüche 1 bis 9, **dadurch gekennzeichnet, daß** ein den Sensor (18) positionierendes Sensorgehäuse (23) unter Verwendung mindestens eines Kabelbinders räumlich fixiert wird.

11. Vorrichtung zur Messung von elektrischen Strömen, die mindestens einen Sensor zur Erfassung einer von der Größe des Stromes abhängigen Feldstärke aufweist, **dadurch gekennzeichnet, daß** sich entlang einander im wesentlichen gegenüberliegender Seiten des Sensors jeweils mindestens Bereiche eines den elektrischen Strom führenden Leiters derart erstrecken, daß die Bereiche mindestens in einer Komponente einer Flußrichtung des elektrischen Stromes hintereinander angeordnet sind.

12. Vorrichtung nach Anspruch 11, **dadurch gekennzeichnet, daß** der Sensor als mindestens ein Magnetfeldsensor ausgebildet ist.

13. Vorrichtung nach Anspruch 11 oder 12, **dadurch gekennzeichnet, daß** zwei Sensorelemente derart verwendet sind, daß durch eine differentielle Auswertung eine Temperaturabhängigkeit des Sensorausgangssignales zumindest überwiegend kompensiert ist.

14. Vorrichtung nach einem der Ansprüche 11 bis 13, **dadurch gekennzeichnet, daß** der Sensor (18) im Bereich einer Stromschiene (1) angeordnet ist.

15. Vorrichtung nach einem der Ansprüche 11 bis 14, **dadurch gekennzeichnet, daß** die Stromschiene (1) benachbart zum Sensor (18) ein u-förmiges Profil aufweist.

16. Vorrichtung nach einem der Ansprüche 11 bis 15, **dadurch gekennzeichnet, daß** der Sensor (18) im Bereich eines Kabels angeordnet ist.

17. Vorrichtung nach Anspruch 16, **dadurch gekennzeichnet, daß** der Sensor mindestens teilweise vom Kabel umschlungen ist.

18. Vorrichtung nach einem der Ansprüche 11 bis 17, **dadurch gekennzeichnet, daß** der Sensor (18) mit mindestens einer Testeinrichtung versehen ist.

19. Vorrichtung nach Anspruch 18, **dadurch gekennzeichnet, daß** die Testeinrichtung mindestens eine Spule umfaßt.

20. Vorrichtung nach einem der Ansprüche 11 bis 19, **dadurch gekennzeichnet, daß** der Sensor (18) mit einer Temperaturüberwachung versehen ist.

21. Vorrichtung nach einem der Ansprüche 11 bis 20, **dadurch gekennzeichnet, daß** der Sensor (18) mindestens eine elektromagnetische Abschirmung aufweist.

22. Vorrichtung nach einem der Ansprüche 11 bis 21, **dadurch gekennzeichnet, daß** ein den Sensor (18) halterndes Sensorgehäuse (23) von mindestens einem Kabelbinder im Bereich des Leiters gehaltert ist.

23. Verfahren und Vorrichtung, welches im Fehlerfall (Ansprechen der Temperaturüberwachung und/oder fehlerhafter Versorgungsspannung der Magnetfeldsensoren) zu einer Aussetzung in die positive bzw. negative Aussteuerungsgrenze des Sensorsystems führt, um bei Umrichteranwendungen ein fail-safe Verhalten ohne zusätzlichen Verkabelungsaufwand zu erreichen.
